# EUROPEAN PATENT APPLICATION

(11) **EP 4 671 796 A1**
(43) Date of publication of application: **31.12.2025**
(21) Application number: 25185446.9
(22) Date of filing: 26.06.2025
(51) Int. Cl.: G01R 31/392, G01R 31/396, H01M 10/42, H01M 10/48

(54) **METHOD AND APPARATUS FOR MONITORING SELF-DISCHARGE PHENOMENA OF ELECTROCHEMICAL CELLS**

(30) Priority: 28.06.2024 IT 202400014944
(71) Applicant: FERRARI S.p.A., 41100 Modena (IT)
(72) Inventor: ZAMPOLINI, Federico, 41100 MODENA (IT); SHANG, Congcong, 41100 MODENA (IT); LUZI, Massimiliano, 41100 MODENA (IT)
(74) Representative: Studio Torta S.p.A.

(57) **Abstract**

A method for monitoring self-discharge phenomena of electrochemical cells, comprising the steps of: a) providing a plurality of electrochemical cells (2), wherein each cell (2) has a first dimension and a second dimension, extending respectively along a first direction and a second direction orthogonal to one another, greater than a third dimension extending along a third direction orthogonal to the first direction and the second direction, wherein each cell (2) comprises a casing (3) and a plurality of layers arranged inside the casing (3), wherein the layers comprise at least one first electrode layer, at least one second electrode layer and at least one first separator layer interposed between the first electrode layer and the second electrode layer; b) arranging the cells (2) inside a container (4), wherein the pressure inside the container (4) is equal to a first pressure; c) bringing the pressure inside the container (4) to a second pressure greater than the first pressure; d) measuring a voltage of each cell (2) of the plurality of cells (2) to detect whether a self-discharge value of said cell (2) is greater than a predetermined threshold, wherein step c) is prior to or at least partially simultaneous with step d), and step d) is prior to a step of assembling the cells (2) into one or more batteries.

## Description

### CROSS-REFERENCE TO RELATED APPLICATIONS

This patent application claims priority from Italian patent application no. 102024000014944 filed on June 28, 2024, the entire disclosure of which is incorporated herein by reference.

### TECHNICAL FIELD

The invention relates to a method for monitoring self-discharge phenomena of electrochemical cells and to an apparatus for monitoring self-discharge phenomena of electrochemical cells.

In particular, the invention advantageously, though not exclusively applies to the monitoring of self-discharge phenomena of electrochemical cells to be assembled into one or more batteries or, optionally, into one or more modules of one or more batteries, for a vehicle, in particular for a car, to which explicit reference will be made in the description below without because of this lacking generality. Other applications could lie in the field of storage systems for different solutions, for example from renewable sources such as solar panels, wind, hydroelectric systems, etc.

### PRIOR ART

As it is known, lithium batteries, thanks to their high energy density, allow electric drive systems to be more and more implemented in the automotive industry. In particular, lithium ions currently represent, from a chemical point of view, the state of the art in the production of high-capacity batteries.

A battery comprises a plurality of electrochemical cells. Optionally, a battery comprises a plurality of modules and each module comprises a plurality of cells.

In particular, a battery used in the automotive industry can comprise tens, hundreds or thousands of cells.

Each cell comprises a casing and a plurality of layers arranged inside the casing. The layers comprise at least two electrode layers (positive and negative, i.e. cathode and anode) and a separator layer interposed between the two electrode layers, and can comprise tens of electrode layers and separator layers interposed between the electrode layers.

There are different types of cells, for example cylindrical cells, pouch cells, prismatic cells.

In particular, pouch cells and prismatic cells have a first dimension and a second dimension (length and width), extending respectively along a first direction and a second direction orthogonal to one another, which are greater than a third dimension (thickness), extending along a third direction orthogonal to the first direction and to the second direction. The casing of a pouch cell comprises a multilayer pouch, while the casing of a prismatic cell comprises a metal can. Conveniently, the pouch cells are externally shaped like a pouch (or bag) and the prismatic cells are externally shaped like a prism, in particular like a parallelepiped.

The cells are subjected to self-discharge phenomena. In particular, over time a cell tends to decrease its charge (namely, its "state of charge", SoC, simultaneously decreasing its voltage), even if the cell is not used, for example while the cell is stored. In other words, the cells tend to self-discharge.

However, some cells have an abnormal self-discharge, being therefore considered as defective cells. In particular, such defective cells have a self-discharge value that is greater than an expected and/or acceptable self-discharge value.

A possible cause of an abnormal self-discharge is the presence of a metal contamination and/or damage to the separator, causing a contact between the positive and negative electrodes and therefore a short circuit.

Typically, the cells are analyzed after having been manufactured, for example while being stored, to detect any defective cells, i.e. cells having an abnormal self-discharge. In particular, a voltage of each cell is periodically measured to detect whether a self-discharge value of said cell is greater than an expected and/or acceptable self-discharge value, i.e. to detect whether said cell has an abnormal self-discharge and is therefore a defective cell. Therefore, if a defective cell is detected, it can be discarded.

Subsequently, the cells are assembled into one or more batteries or, optionally, into one or more modules of one or more batteries. To this aim, the cells are compressed orthogonally to the respective main faces to make them work at their best.

However, some cells can show an abnormal self-discharge, thus being considered as defective cells, only after they have been assembled into one or more batteries or, optionally, into one or more modules of one or more batteries.

A possible cause is the presence of a latent metal contamination and/or latent damage to the separator, i.e. a metal contamination and/or damage to the separator that was already present but had not been detected, for example because it was small and not such as to cause a contact between the positive and negative electrodes and therefore a short circuit.

If a battery (or a module) contains even one defective cell, the entire battery (or the entire module) must be discarded, with obvious economic and environmental drawbacks.

In addition, if the battery (or the module) containing one or more defective cells is mounted on vehicles that are already on the market, it may be necessary to carry out a recall campaign, with obvious economic and image repercussions.

### DESCRIPTION OF THE INVENTION

The object of the invention is to provide a method for monitoring self-discharge phenomena in electrochemical cells and an apparatus for monitoring self-discharge phenomena of electrochemical cells, which are at least partially free from the drawbacks described above and, at the same time, are simple and economic to be manufactured and implemented.

According to the invention, there are provided a method for monitoring self-discharge phenomena in electrochemical cells and an apparatus for monitoring self-discharge phenomena of electrochemical cells as claimed in the independent claims attached hereto and, preferably, in any one of the dependent claims directly or indirectly depending on the independent claims.

The appended claims describe preferred embodiments of the invention and form an integral part of the description.

### BRIEF DESCRIPTION OF THE DRAWINGS

The invention will be best understood upon perusal of the following detailed description of a preferred embodiment, which is provided by way of non-limiting example, with reference to the accompanying drawings, wherein:
- figure 1 is a schematic view of an apparatus and a method according to a first embodiment of the invention; and
- figure 2 is a schematic view of an apparatus and a method according to a second embodiment of the invention.

### EMBODIMENTS OF THE INVENTION

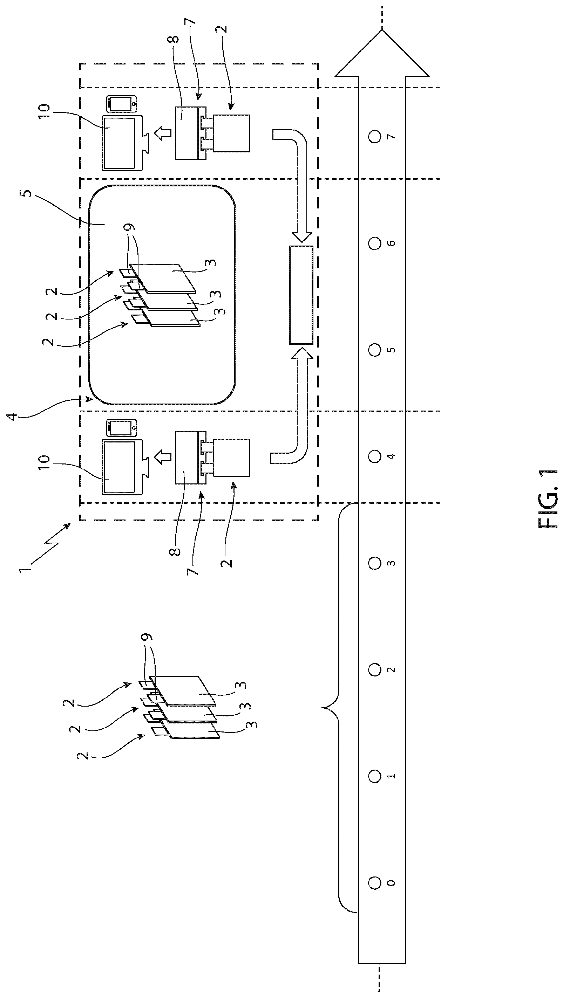

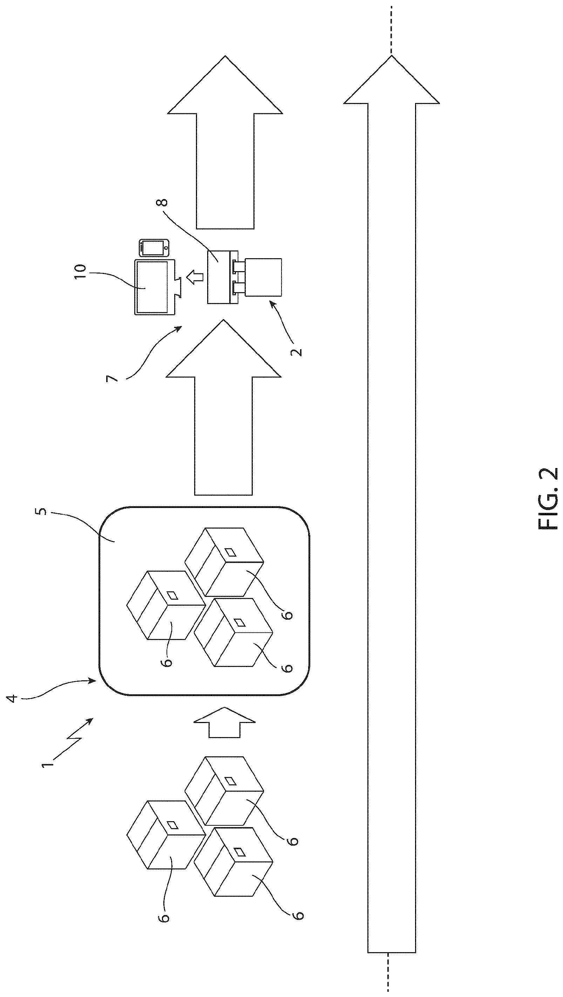

With reference to figures 1 and 2, number 1 indicates an apparatus for monitoring self-discharge phenomena of electrochemical cells 2 according to the invention.

The apparatus 1, described in detail below, implements a method for monitoring self-discharge phenomena of electrochemical cells 2 according to the invention.

The method comprises a plurality of steps, described in detail below.

The method comprises a step a) of providing a plurality of electrochemical cells 2, wherein each cell 2 has a first dimension and a second dimension, extending respectively along a first direction and a second direction orthogonal to one another, which are greater than a third dimension, extending along a third direction orthogonal to the first direction and to the second direction. Each cell 2 comprises a casing 3 and a plurality of layers arranged inside the casing 3. The layers comprise at least one first electrode layer, at least one second electrode layer and at least one first separator layer interposed between the first electrode layer and the second electrode layer.

In particular, the cells 2 comprise planar cells, which comprise cells having planar electrode plates (*"blanks"*)*.* In particular, the planar cells comprise pouch cells, in which the casing 3 comprises a multilayer pouch, and prismatic cells, in which the casing 3 comprises a metal can. Conveniently, the pouch cells are externally shaped like a pouch (or bag) and the prismatic cells are externally shaped like a prism, in particular like a parallelepiped.

Conveniently, the planar cells comprise so-called "Z-folded" cells (which may be pouch cells or prismatic cells, depending on the type of casing 3), in which the electrode layers are arranged parallel to one another and the separator layer is arranged "zigzag"-like between the electrode layers, thus being interposed between the electrode layers.

Conveniently, one of the first electrode layer and the second electrode layer is a cathode layer and the other one of the first electrode layer and the second electrode layer is an anode layer.

Preferably, each cell 2 comprises a third electrode layer (of the same type, i.e. cathode or anode, as the first electrode layer) and at least one second separator layer interposed between the second electrode layer and the third electrode layer. Conveniently, each cell 2 can comprise tens of electrode layers and separator layers interposed between the electrode layers.

The method comprises a step b) of arranging the cells 2 inside a container 4, wherein pressure inside the container 4 is equal to a first pressure.

In particular, the container 4 (schematically shown in figures 1 and 2) can have any shape and size. Conveniently, the container 4 defines a chamber 5, which can have any shape and size, in which the cells 2 can be housed, i.e. in which the cells 2 can be arranged. In step b), the pressure inside the chamber 5 is equal to the first pressure.

The method comprises a step c) of bringing the pressure inside the container 4 to a second pressure greater than the first pressure.

In particular, the pressure inside the container 4, in which the cells 2 are arranged, is brought to the second pressure, which is greater than the first pressure. In other words, the pressure inside the container 4, in which the cells 2 are arranged, is increased from the first pressure to the second pressure. Conveniently, the container 4 is controlled so that the pressure inside the container 4 is equal to the second pressure, which is greater than the first pressure. In step c), the pressure inside the chamber 5 is equal to the second pressure.

Conveniently, since the cells 2 are arranged inside the container 4 (in particular, inside the chamber 5) and the pressure inside the container 4 (in particular, inside the chamber 5) is equal to the second pressure, then the cells 2 are subjected to the second pressure, which is equivalent to a compressive force on the cells 2, in particular on the two faces (of the cells 2) orthogonal to the third direction, i.e. the two faces (of the cells 2) having a larger surface.

The method comprises a step d) of measuring a voltage of each cell 2 of the plurality of cells 2 to detect whether a self-discharge value of said cell 2 is above a predetermined threshold.

In particular, for each cell 2, a first voltage value, which is for example a nominal voltage value or a previously measured voltage value, is considered and a second voltage value is measured. Conveniently, the first voltage value is greater than or equal to the second voltage value and typically greater than the second voltage value. Conveniently, the self-discharge value of each cell 2 is correlated to the comparison between the first voltage value and the second voltage value, in particular to the difference (for example, measured in mV) between the first voltage value and the second voltage value. Preferably, the self-discharge value of each cell 2 is also correlated to the time distance (for example, measured in days) between the first voltage value (i.e. an instant associated with the first voltage value) and the second voltage value (i.e. an instant associated with the second voltage value). For example, the self-discharge value of each cell 2 is the ratio between the difference between said difference and said time distance.

Conveniently, the predetermined threshold corresponds to a maximum expected and/or acceptable self-discharge value.

Conveniently, if the self-discharge value of a specific cell 2 is greater than the predetermined threshold, an abnormal self-discharge is detected for said cell 2, i.e. the self-discharge of said cell 2 is greater than expected and/or acceptable.

Step c) is prior to or at least partially simultaneous with step d), and step d) is prior to a step of assembling the cells (2) into one or more batteries.

In particular, there is no time overlap between step c) and step d), or there is at least a partial time overlap between step c) and step d).

In other words, when step d) is performed, it is no longer true that the pressure inside the container 4 is equal to the second pressure, i.e. the pressure inside the container 4 is no longer equal to the second pressure, or there is a time interval in which step d) is performed and the pressure inside the container 4 is equal to the second pressure.

Step d) is prior to a step of assembling the cells 2 into one or more batteries (namely, battery modules).

In particular, when step d) is performed, the cells 2 are not assembled (yet) into one or more batteries or, optionally, into one or more modules of one or more batteries.

In other words, the cells 2 are (optionally) assembled into one or more batteries or, optionally, into one or more modules of one or more batteries after step d).

Preferably, the container 4 contains air and the first pressure is substantially equal to the ambient pressure.

In particular, inside the chamber 5 there is air. Conveniently, the first pressure is substantially equal to the ambient pressure *P_{amb}*, i.e. the normal (or standard) atmospheric pressure defined as *P_{amb}* = 101325 *Pa**.*** In other words, when the cells 2 are arranged inside the container 4, the cells 2 are housed in the chamber 5, which contains air at a pressure equal to the ambient pressure.

Conveniently, when the cells 2 are arranged inside the container 4, i.e. housed in the chamber 5, the chamber 5 is in fluid communication with the environment outside the container 4. Therefore, the first pressure is substantially equal to the ambient pressure. Preferably, the cells 2 are introduced into the container 4 through an opening of the container 4 in direct fluid communication with, i.e. facing, the environment outside the container 4 where there is air at a pressure equal to the ambient pressure. Conveniently, the second pressure is greater than the ambient pressure. In particular, when the pressure inside the container 4 is brought to the second pressure, the chamber 5 is not in fluid communication with the environment outside the container 4.

Preferably, the container 4 comprises an autoclave and/or a hyperbaric chamber.

In particular, the container 4 can be hermetically sealed with respect to the environment outside the container 4. In other words, the chamber 5 can be hermetically isolated with respect to the environment outside the container 4. Conveniently, the container 4 is hermetically sealed with respect to the outside environment, when the pressure inside the container 4 is equal to the second pressure.

The chamber 5 conveniently has a horizontal or vertical development. For example, the chamber 5 is cylindrical with a horizontal or vertical axis.

Optionally (figure 2), step a) comprises providing at least one housing 6, wherein the cells 2 are housed in said at least one housing 6, and step b) comprises arranging said at least one housing 6 within the container 4.

In particular, said at least one housing 6 is configured to house the cells 2. For example, said at least one housing 6 comprises at least one box and/or at least one rack.

In the non-limiting embodiment shown in figure 2, said at least one housing 6 is a plurality of boxes, in particular three boxes, in which the cells 2 are housed.

Conveniently, if in step a) the cells 2 are housed in said at least one housing 6, in step b) said at least one housing 6 can be arranged inside the container 4, in particular in the chamber 5. In other words, the cells 2 are arranged inside the container 4, in particular in the chamber 5, by means of said at least one housing 6 in which the cells 2 are housed.

Preferably, step d) is subsequent to step c) and comprises the step of extracting a cell 2 from the container 4 before measuring the voltage of said cell 2.

In particular, step c) is prior to step d), i.e. there is no time overlap between step c) and step d). In other words, when step d) is performed, it is no longer true that the pressure inside the container 4 is equal to the second pressure, i**.**e. the pressure inside the container 4 is no longer equal to the second pressure. Conveniently, after having performed step c), the pressure inside the container 4 is decreased, preferably from the second pressure to the first pressure, and at least one cell 2 is extracted from the container 4. Subsequently, the voltage of each cell 2 extracted from the container 4 is measured.

Preferably, the method comprises a step e), prior to step c), of measuring a voltage of each cell 2 of the plurality of cells 2, wherein step d) comprises comparing the voltages measured in step e) with respective voltages measured in step d) to detect whether a self-discharge value of said cell 2 is above a predetermined threshold.

In particular, step e) is prior to step c) and, for example, prior to step b).

In other words, when step e) is performed, the pressure inside the container 4 has not yet been brought to the second pressure greater than the first pressure and, for example, the cells 2 have not yet been arranged inside the container 4. Conveniently, the cells 2 are inside the container 4, wherein the pressure inside the container 4 is equal to the first pressure, or the cells 2 are outside the container 4.

Conveniently, in step e), said first voltage value is measured, which is a voltage value measured prior to step d), in which the second voltage value is measured. Conveniently, the self-discharge value of each cell 2 is correlated to said comparison between the first voltage value, measured during step e), and the second voltage value, measured during step d), in particular taking into account the possible time distance between step e) and step d).

Preferably, step c) has a duration greater than a predetermined period. In particular, the duration of step c) is further monitored, to avoid any cycle errors or detect problems with the equipment.

In particular, the pressure inside the container 4 is brought to the second pressure greater than the first pressure for a duration greater than the predetermined period, i.e. the cells 2 are kept inside the container 4, in which the pressure is equal to the second pressure, at least for the predetermined period. For example, the predetermined period is a plurality of days, for example two days.

Preferably, the second pressure is between a first predetermined threshold and a second predetermined threshold.

In particular, the second pressure, to which the cells 2 are subjected and which is equivalent to a compressive force acting on the cells 2, is greater than the first predetermined threshold and smaller than the second predetermined threshold.

Preferably, the first predetermined threshold corresponds to a compressive force on the cells 2, in particular on the two faces (of the cells 2) orthogonal to the third direction, which is greater than or equal to a compressive force to which the cells 2 will be subjected, in particular on the two faces (of the cells 2) orthogonal to the third direction, when they will be assembled into one or more batteries or, optionally, into one or more modules of one or more batteries and will begin to be used. In other words, the first predetermined threshold corresponds to a compressive force on the cells 2, in particular on the two faces (of the cells 2) orthogonal to the third direction, which is greater than or equal to a compressive force to which the cells 2 will be subjected in the instant of "beginning of life" of the batteries.

For example, the first predetermined threshold corresponds to a compressive force (in detail, determined by the pressure inside the container 4) on the cells 2, in particular on the two faces (of the cells 2) orthogonal to the third direction, which is equal to 2000 N**.**

Conveniently, the second predetermined threshold corresponds to a compressive force on the cells 2, in particular on the two faces (of the cells 2) orthogonal to the third direction, which is smaller than a maximum compressive force the cells 2 can withstand. Conveniently, the maximum compressive force the cells 2 can withstand depends on the type of cells 2.

Preferably, the method comprises the step of discarding each cell 2 such that the self-discharge value of said cell 2 is above said predetermined threshold.

In particular, if in step d) it is detected that the self-discharge value of a specific cell 2 is greater than the predetermined threshold, said cell 2 is discarded, i.e**.** it is removed from the plurality of cells 2. Conveniently, said cell 2 is replaced with another cell 2.

Figure 1 shows a non-limiting example of the method, in particular according to a first embodiment of the invention. For example, we consider a manufacturer of cells 2, namely a company that manufactures cells 2 to supply them to a user of cells 2. Conveniently, the time unit (indicated on the time arrow) is one day**.**

In particular, the cells 2 are manufactured on day 0, and left for four days without being compressed, for example while being stored. On day 4, the aforementioned first voltage value of each cell 2 (step e)) is measured. On the following two days (days 5 and 6), the cells 2 are arranged inside the container 4, wherein the pressure inside the container 4 is equal to the first pressure (step b)), and the pressure inside the container 4 is brought to the second pressure greater than the first pressure (step c)). On day 7, the aforementioned second voltage value of each cell 2 is measured (step d)) to detect whether a self-discharge value of said cell 2 is above a predetermined threshold. Conveniently, if it is detected that the self-discharge value of a specific cell 2 is greater than the predetermined threshold, said cell 2 is discarded, i.e. it is removed from the plurality of cells 2.

In the non-limiting embodiment shown in figure 1, step d) is performed after step c), i.e. step c) is prior to step d). In particular, the cells 2 are extracted from the container 4 before measuring the aforementioned second voltage value of each cell 2. However, step d) could be carried out at least partially simultaneously with step c), i.e. step c) could be at least partially simultaneous with step d), for example the aforementioned second voltage value of each cell 2 could be measured when the cells 2 are inside the container 4 and are subjected to the second pressure.

Figure 2 shows a non-limiting example of the method, in particular according to a second embodiment of the invention. For example, we consider a user of cells 2, i.e. a company that receives cells 2 from a manufacturer of cells 2 in order to use them.

In particular, the user of cell 2 receives from the manufacturer of cells 2 at least one housing 6, in which the cells 2 are housed (step a)). For example, said at least one housing 6 is a plurality of boxes, in particular three boxes, in which the cells 2 are housed. Said at least one housing 6, in which the cells 2 are housed, is arranged inside the container 4, wherein the pressure inside the container 4 is equal to the first pressure (step b)), and the pressure inside the container 4 is brought to the second pressure greater than the first pressure (step c)). Subsequently, a voltage value of each cell 2 is measured (step d)) to detect whether a self-discharge value of said cell 2 is above a predetermined threshold. Conveniently, if it is detected that the self-discharge value of a specific cell 2 is greater than the predetermined threshold, said cell 2 is discarded, i.e. it is removed from the plurality of cells 2.

In the non-limiting embodiment shown in figure 2, step d) is performed after step c), i.e. step c) is prior to step d). In particular, the cells 2 are extracted from the container 4 before measuring the voltage value of each cell 2. However, step d) could be carried out at least partially simultaneously with step c), i.e. step c) could be at least partially simultaneous with step d), for example the voltage value of each cell 2 could be measured when the cells 2 are inside the container 4 and are subjected to the second pressure.

Figures 1 and 2 show non-limiting examples of an apparatus 1 according to the invention.

The apparatus 1 comprises a container 4 configured to house a plurality of electrochemical cells 2 described above, and a detection system 7.

In the non-limiting embodiments shown herein, the cells 2 are pouch cells.

The detection system 7 is configured to measure a voltage of each cell 2 of the plurality of cells 2 to detect whether a self-discharge value of said cell 2 is above a predetermined threshold.

The apparatus 1 is configured to assume a first configuration, in which the pressure inside the container 4 is equal to a first pressure, and a second configuration, in which the pressure inside the container 4 is equal to a second pressure greater than the first pressure.

In particular, the first configuration is an introduction configuration, in which the cells 2 are introduced into the container 4 and are subjected to the first pressure, and the second configuration is a compression configuration, in which the cells 2 are inside the container 4 and are subjected to the second pressure greater than the first pressure.

Conveniently, when the apparatus 1 is in the first configuration, the container 4 is open, in particular when the cells 2 are introduced into the container 4, and can subsequently be closed, in particular when the cells 2 are inside the container 4 and are subjected to the first pressure.

Conveniently, when the apparatus 1 is in the second configuration, the container 4 is closed, in particular when the cells 2 are inside the container 4 and are subjected to the second pressure.

Preferably, the container 4 contains air and the first pressure is substantially equal to the ambient pressure.

In particular, the fluid inside the container 4, in particular the chamber 5, is air and the first pressure is substantially equal to the ambient pressure *P_{amb}***,** i.e. the normal (or standard) atmospheric pressure defined as *P_{amb} =* 101325 *Pa***.** In other words, when the apparatus 1 is in the first configuration, the cells 2 are subjected to a pressure equal to the ambient pressure. Preferably, when the apparatus 1 is in the first configuration, the cells 2 are introduced into the container 4 through an opening of the container 4 in direct fluid communication with, i.e. facing, the environment outside the container 4 where there is air at a pressure equal to the ambient pressure. Conveniently, the second pressure is greater than the ambient pressure. In particular, when the apparatus 1 is in the second configuration, the chamber 5 is not in fluid communication with the environment outside the container 4.

Preferably, the container 4 comprises an autoclave.

In particular, the autoclave is an apparatus comprising a fixed part and a movable part, which is movable relative to the fixed part. Conveniently, the fixed part of the autoclave is hollow and defines the chamber 5, and the movable part of the autoclave is configured to define an open configuration of the autoclave, in which the chamber 5 is in fluid communication with the environment outside the autoclave, and a closed configuration of the autoclave, in which the chamber 5 is not in fluid communication with the environment outside the autoclave. Typically, the autoclave is not configured to accommodate human beings inside the chamber 5**.**

Preferably, the container 4 comprises a hyperbaric chamber.

In particular, the hyperbaric chamber is an apparatus comprising a fixed part and a movable part, which is movable relative to the fixed part. Conveniently, the fixed part of the hyperbaric chamber is hollow and defines the chamber 5, and the movable part of the hyperbaric chamber is configured to define an open configuration of the hyperbaric chamber, in which the chamber 5 is in fluid communication with the environment outside the hyperbaric chamber, and a closed configuration of the hyperbaric chamber, in which the chamber 5 is not in fluid communication with the environment outside the hyperbaric chamber. Typically, the hyperbaric chamber is configured to also accommodate human beings inside the chamber 5.

Preferably, the detection system 7 comprises at least one voltage meter 8 configured to measure a voltage of each cell 2 of the plurality of cells 2, and a plurality of electrical contacts configured to be in contact with terminal poles 9 of the cells 2 and electrically connected to said at least one voltage meter 8.

In particular, each cell 2 comprises at least two terminal poles 9 (positive and negative, i.e. cathode and anode) arranged on the same side of the cell 2, like in the non-limiting embodiments shown herein, or arranged on opposite sides of the cell 2. When the voltage of the cell 2 is measured, the cell 2 is electrically connected to said at least one voltage meter 8, since the two terminal poles 9 are in contact with the electrical contacts, which are electrically connected to said at least one meter 8. Obviously, the number and the arrangement of the terminals 31 can vary based on the configuration of the cell 2 to be tested (for example, there could be a greater number of terminals and/or these could be arranged on different sides of the cell 2).

Preferably, the voltage meter 8 is configured to be electrically connected to a plurality of cells 2 simultaneously. In particular, the two terminal poles 9 of each cell 2 of the plurality of cells 2 are in contact with the electrical contacts that are electrically connected to said at least one voltage meter 8 by means of electrical cables.

For example, the voltage meter 8 is arranged on the outside of the container 4, so as to measure a voltage of each cell 2 of the plurality of cells 2 when the cells 2 are on the outside of the container 4.

In addition or alternatively, the voltage meter 8 can be housed inside the container 4, so as to measure a voltage of each cell 2 of the plurality of cells 2 when the cells 2 are inside the container 4.

Advantageously, though not in a limiting manner, the detection system 8 is configured to be able to disconnect the or some electronic components (voltage meter 29, printed circuit 34, detection unit 35) from the cell 2 during the self-discharge observation period. In this way, any passive absorption is prevented from affecting the result of the measurement.

Conveniently, the detection system 7 comprises a detection unit 10 (schematically shown in figures 1 and 2) communicatively coupled to the voltage meter 8 and configured to detect, for each cell 2, whether a self-discharge value of said cell 2 is greater than a predetermined threshold.

An analysis of the features of the method and of the apparatus 1 clearly reveals the advantages of the invention.

In particular, arranging the cells 2 inside the container 4, wherein the pressure inside the container 4 is equal to a first pressure, bringing the pressure inside the container 4 to a second pressure greater than the first pressure and measuring a voltage of each cell 2 of the plurality of cells 2 to detect whether a self-discharge value of said cell 2 is greater than a predetermined threshold allows for the detection of possible defective cells 2, i.e. cells 2 having an abnormal self-discharge, before the cells 2 are assembled into one or more batteries or, optionally, into one or more modules of one or more batteries.

The method also allows for the detection of possible cells 2 that could show an abnormal self-discharge only after they have been assembled into one or more batteries or, optionally, into one or more modules of one or more batteries.

In particular, the method also allows for the detection of a latent metal contamination and/or latent damage to the separator, i.e. a metal contamination and/or damage to the separator that was already present but had not been detected, for example because it was small. Indeed, the step of bringing the pressure inside the container 4 to the second pressure greater than the first pressure, which anticipates the compression to which the cells 2 will be subjected when they will be assembled, involves bringing the positive and negative electrodes closer together, triggering a possible short circuit in case of latent metal contamination and/or latent damage to the separator.

The method reveals any defective cells 2 without using mechanical devices that depend on the specific type of cells 2, for example on the shape and/or size of the cells 2. Indeed, it is sufficient to place the cells 2 (or, optionally, to place said at least one housing 6 in which the cells 2 are housed) inside the container 4 and to increase the pressure inside the container 4, in which the cells 2 are arranged, from the first pressure to the second pressure, and to measure a voltage of each cell 2 of the plurality of cells 2 to detect whether a self-discharge value of said cell 2 is greater than a predetermined threshold.

The compressive force on the cells 2, in particular on the two faces (of the cells 2) orthogonal to the third direction, can be easily controlled by acting upon the pressure inside the container 4, in particular by acting upon the second pressure.

The method can easily be implemented by both a manufacturer of cells 2 and a by user of cells 2.

The apparatus 1 easily implements the method and obtains the advantages thereof through the container 4 and the detection system 7.

In particular, the container 4 and the detect system 7 do not depend on the specific type of cells 2, for example on the shape and/or size of the cells 2.

The method and the apparatus 1 discard only the defective cells instead of discarding the entire battery (or the entire module) containing such defective cells, with evident economic and environmental advantages.

Furthermore, the method and the apparatus 1 decrease the probability of having to carry out a recall campaign, with evident economic and image advantages.

Finally, the method and the apparatus 1 can clearly be subjected to changes, though without going beyond the scope of protection set forth in the appended claims.

### LIST OF THE REFERENCE NUMBERS OF THE FIGURES

- 1: apparatus
- 2: cell
- 3: casing
- 4: container
- 5: chamber
- 6: housing
- 7: detection system
- 8: voltage meter
- 9: terminal pole
- 10: detection unit

## Claims

1. Method for monitoring self-discharge phenomena of electrochemical cells, comprising the steps of:
a) providing a plurality of electrochemical cells (2), wherein each cell (2) has a first dimension and a second dimension, extending respectively along a first direction and a second direction orthogonal to each other, greater than a third dimension extending along a third direction orthogonal to the first direction and the second direction, wherein each cell (2) comprises a casing (3) and a plurality of layers arranged within the casing (3), wherein the layers comprise at least a first electrode layer, at least a second electrode layer and at least a first separator layer interposed between the first electrode layer and the second electrode layer;
b) arranging the cells (2) inside a container (4), wherein pressure inside the container (4) is equal to a first pressure;
c) bringing the pressure inside the container (4) to a second pressure greater than the first pressure;
d) measuring a voltage of each cell (2) of the plurality of cells (2) to detect whether a self-discharge value of said cell (2) is above a predetermined threshold,
wherein step c) is prior to or at least partially simultaneous with step d), and step d) is prior to a step of assembling the cells (2) into one or more batteries.

2. Method as claimed in claim 1, wherein the container (4) contains air and the first pressure is substantially equal to the ambient pressure.

3. Method as claimed in claim 1 or 2, wherein the container (4) comprises an autoclave.

4. Method as claimed in any of the preceding claims, wherein the container (4) comprises a hyperbaric chamber.

5. Method as claimed in any of the preceding claims, wherein step a) comprises providing at least one housing (6), wherein the cells (2) are housed in the at least one housing (6), and step b) comprises arranging the at least one housing (6) within the container (4).

6. Method as claimed in any of the preceding claims, wherein step d) is subsequent to step c) and comprises the step of extracting a cell (2) from the container (4) before measuring the voltage of said cell (2).

7. Method as claimed in any of the preceding claims, comprising a step e), prior to step c), of measuring a voltage of each cell (2) of the plurality of cells (2), wherein step d) comprises comparing the voltages measured in step e) with the respective voltages measured in step d) to detect whether a self-discharge value of said cell (2) is above a predetermined threshold.

8. Method as claimed in any of the preceding claims, wherein step c) has a duration greater than a predetermined period.

9. Method as claimed in any of the preceding claims, wherein the second pressure is between a first predetermined threshold and a second predetermined threshold.

10. Method as claimed in any of the preceding claims, comprising the step of discarding each cell (2) such that the self-discharge value of said cell (2) is above said predetermined threshold.

11. Apparatus for monitoring self-discharge phenomena of electrochemical cells, comprising:
- a container (4) configured to house a plurality of electrochemical cells (2), wherein each cell (2) has a first dimension and a second dimension, extending respectively along a first direction and a second direction orthogonal to each other, greater than a third dimension extending along a third direction orthogonal to the first direction and the second direction, wherein each cell (2) comprises a casing (3) and a plurality of layers arranged within the casing (3), wherein the layers comprise at least a first electrode layer, at least a second electrode layer and at least a first separator layer interposed between the first electrode layer and the second electrode layer; and
- a detection system (7) configured to measure a voltage of each cell (2) of the plurality of cells (2) to detect whether a self-discharge value of said cell (2) is above a predetermined threshold,
wherein the apparatus (1) is configured to assume a first configuration, wherein the pressure inside the container (4) is equal to a first pressure, and a second configuration, wherein the pressure inside the container (4) is equal to a second pressure greater than the first pressure.

12. Apparatus as claimed in claim 11, wherein the container (4) contains air and the first pressure is substantially equal to the ambient pressure.

13. Apparatus as claimed in claim 11 or 12, wherein the container (4) comprises an autoclave.

14. Apparatus as claimed in any of claims 11 to 13, wherein the container (4) comprises a hyperbaric chamber.

15. Apparatus as claimed in any of claims 11 to 14, wherein the detection system (7) comprises at least one voltage meter (8) configured to measure a voltage of each cell (2) of the plurality of cells (2), and a plurality of electrical contacts configured to be in contact with terminal poles (9) of the cells (2) and electrically connected to the at least one voltage meter (8).
